# EUROPEAN PATENT SPECIFICATION

(11) **EP 3 372 336 B1**
(45) Date of publication and mention of the grant of the patent: **21.08.2019**
(21) Application number: 18154081.6
(22) Date of filing: 30.01.2018
(51) Int. Cl.: B23K 35/26, B23K 35/02, C22C 13/02, H01L 21/52, H01L 23/00, B23K 101/40

(54) **SOLDER ALLOY AND JOINT STRUCTURE**
LÖTLEGIERUNG UND VERBINDUNGSTRUKTUR
ALLIAGE DE BRASAGE ET STRUCTURE D'ARTICULATION

(30) Priority: 07.03.2017 JP 2017043243
(43) Date of publication of application: 12.09.2018
(73) Proprietor: Panasonic Intellectual Property Management Co., Ltd., Osaka-shi, Osaka 540-6207 (JP)
(72) Inventor: KITAURA, Hidetoshi, Osaka, 540-6207 (JP); FURUSAWA, Akio, Osaka, 540-6207 (JP); HINE, Kiyohiro, Osaka, 540-6207 (JP); SAKAI, Kazuki, Osaka, 540-6207 (JP)
(74) Representative: Vigand, Philippe

(56) References cited:
- WO-A1-2012/077228
- JP-A- 2004 106 027
- US-A1- 2011 198 755
- US-A1- 2011 220 704
- US-A1- 2016 035 690

## Description

### 1. Technical Field

The present disclosure relates to a solder alloy used for a power module or the like and a joint structure using the solder alloy.

### 2. Description of the Related Art

As an example of a solder alloy and a joint structure using the solder alloy of the related art, Japanese Patent No. 4147875 discloses a joint structure including a brazing filler metal that contains 5 mass% or more and 20 mass% or less of Sb, 0.01 mass% or more and 5 mass% or less of Te, and a remainder of Sn, and that is formed of any additives and unavoidable impurities, in which a board and a semiconductor device assembled by using this brazing filler metal are joined.

### SUMMARY

In a solder alloy of the present disclosure, an Sb content is 3 wt% or more and 15 wt% or less, a Te content is 0.01 wt% or more and 1.5 wt% or less, and an Au content is 0.005 wt% or more and 1 wt% or less, and a remainder that is Sn.

According to the present disclosure, there is provided a solder alloy that improves crack resistance of a solder joint and thus realizes a high level of reliability, and a joint structure using the solder alloy.

### BRIEF DESCRIPTION OF THE DRAWINGS

FIG. 1 is an explanatory drawing of a method for manufacturing a joint structure in an exemplary embodiment of the present disclosure; and
FIG. 2 is an explanatory drawing of the method for manufacturing a joint structure in the exemplary embodiment of the present disclosure.

### DETAILED DESCRIPTION

A problem in the related art will be briefly described before describing an exemplary embodiment.

In the solder alloy disclosed in Japanese Patent No. 4147875, joint reliability is improved by adding Te, Ag, Cu, Fe, and Ni to Sn, but the improvement has not yet reached the realization of reliability of connection capable of withstanding a heat cycle test of 1000 cycles or more. Therefore, it has been required to realize sufficient joint reliability for the purpose of on-vehicle mounting or the like in which connection reliability is required for a long period of time.

The present disclosure has been made to solve the above-described problem of the related art, and an object thereof is to provide a solder alloy that improves crack resistance of a solder joint and thus realizes a high level of reliability.

In a solder alloy of the present disclosure, an Sb (antimony) content is 3 wt% or more and 15 wt% or less, a Te (tellurium) content is 0.01 wt% or more and 1.5 wt% or less, an Au (gold) content is 0.005 wt% or more and 1 wt% or less, and a remainder that is Sn (tin).

In the present specification, the "content" is a ratio of a weight of each element to a total weight of the solder alloy, and is expressed in a unit of wt% (weight percentage).

The solder alloy may have any form and may be used for soldering, for example, alone or together with other components other than metals (such as flux).

In the solder alloy of the present disclosure, since Te is added to become a predetermined content, an elongation due to solid solution of Te in Sn occurs. Furthermore, since in the solder alloy of the present disclosure, both Te and Au are added to become a predetermined content, Au having different ionic radius is complicatedly substituted with Te solutionized in Sn at high temperature to cause dislocation, and thus elongation at high temperature is improved. Therefore, the solder alloy of the present disclosure has excellent elongation at high temperature compared to Sn-Sb solder to which only Te is added. Accordingly, it is possible to absorb repetitive stress generated during the heat cycle, whereby a high level of reliability of a joint structure can be realized.

In the joint structure of an exemplary embodiment, a semiconductor element and a circuit board are joined via a solder joint layer containing Sb, Te, Au, and Sn, and Sn-Ni (tin-nickel) alloy or Sn-Cu (tin-copper) alloy are included at an interface between the solder joint layer and a metallized layer of the semiconductor element and at an interface between the solder joint layer and a plated layer of the circuit board.

The joint structure of the above exemplary embodiment has excellent crack resistance in a heat cycle and a high level of reliability.

Hereinafter, the solder alloy according to the exemplary embodiment of the present disclosure will be described with reference to the drawings. Solder Alloy 105

Solder alloy 105 is an alloy containing Sb, Te, Au, and a remainder is Sn.

The Sb content in solder alloy 105 is 3 wt% or more and 15 wt% or less. In a case where the Sb content in the solder alloy is in such a range, a thermal fatigue characteristic of the solder joint can be improved.

In solder alloy 105, the Te content is 0.01 wt% or more and 1.5 wt% or less, the Au content is 0.005 wt% or more and 1 wt% or less, and the remainder is Sn. Au in solder alloy 105 may be provided by plating Au on a surface of the solder alloy containing Sb, Te, and a remainder is Sn. In this case, Au melts into solder alloy 105 during melting of solder alloy 105. In the solder alloy of the present disclosure, since in the solder alloy of the present disclosure, both Te and Au are added to become a predetermined content, Au having different ionic radius is complicatedly substituted with Te solutionized in Sn at high temperature to cause dislocation, and thus elongation at high temperature is improved. Therefore, the solder alloy of the present disclosure has excellent elongation at high temperature compared to Sn-Sb solder to which only Te is added. Accordingly, it is possible to absorb repetitive stress generated during the heat cycle and improve crack resistance, whereby a high level of reliability of a joint structure can be realized.

A size of solder alloy 105 may vary depending on the joint structure to be manufactured, but solder alloy 105 having, for example, 10 mm square and a thickness of 0.05 mm or more and 0.5 mm or less may be used. In a case where the thickness of solder alloy 105 is 0.5 mm or less, thermal resistance of the solder joint to be formed does not become high and thus the heat of semiconductor element 101 can be released efficiently. In a case where the thickness of solder alloy 105 is 0.05 mm or more, generation of voids at the time of solder joining can be suppressed, and the therefore thermal resistance of the solder joint can be improved.

Next, the joint structure according to the exemplary embodiment of the present disclosure will be described with reference to the drawings. Semiconductor Element 101

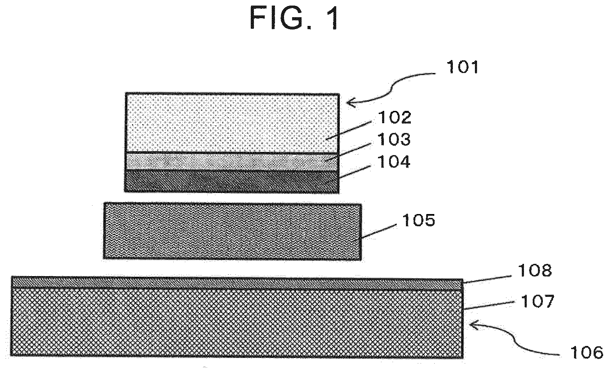

Semiconductor element 101 shown in FIG. 1 includes silicon chip 102, ohmic layer 103 formed on a lower surface of silicon chip 102, and metallized layer 104 formed on a lower surface of ohmic layer 103. Regarding the ease of manufacturing, silicon chip 102 preferably has a vertical length of 10 mm, a horizontal length of 10 mm, and a thickness of 0.2 mm, but each length is not limited thereto, and the chip can have various dimensions.

Ohmic layer 103 of semiconductor element 101 is a layer made of any pure metal or alloy, and for example, Ti, Al, Cr, Ni, an alloy containing these metals, or the like can be used, but the layer is not limited to these metals. An appropriate ohmic joint can be obtained by using the above-described metals for the ohmic layer. A thickness of ohmic layer 103 is not particularly limited, but may be 0.05 µm or more and 0.5 µm or less, and may be 0.1 µm for example. In a case where ohmic layer 103 has such a thickness, it is easy to secure a resistance value and joint reliability.

Metallized layer 104 of semiconductor element 101 is a layer made of any pure metal or alloy, and for example, Ni, Cu, an alloy containing these metals, or the like can be used, but the layer is not limited thereto. A thickness of metallized layer 104 is not particularly limited, but may be, for example, 0.5 µm or more and 10 µm or less, and may be 1 µm for example. In a case where metallized layer 104 has such a thickness, it is possible to firmly performing joining with the solder alloy.

### Circuit Board 106

Circuit board 106 includes lead frame 107 and plated layer 108 formed on a surface of lead frame 107.

As a material of lead frame 107 of circuit board 106, a material having high thermal conductivity such as metals or ceramics can be used. As a material of lead frame 107, for example, copper, aluminum, alumina, aluminum nitride, silicon nitride, or the like can be used, but the material is not limited thereto. Regarding the ease of manufacturing, lead frame 107 preferably has a vertical length of 20 mm, a horizontal length of 20 mm, and a thickness of 1 mm, but each length is not limited thereto, and the chip can have various dimensions.

Plated layer 108 of circuit board 106 is a layer made of any pure metal or alloy, and for example, Ni, Cu, an alloy containing these metals, or the like can be used, but the layer is not limited thereto. A thickness of the plated layer is not particularly limited, but may be, for example, 0.5 µm or more and 10 µm or less, and may be 1 µm for example. In a case where the plated layer has such a thickness, the plated layer can be strongly joined to the solder alloy. Joint Structure 201

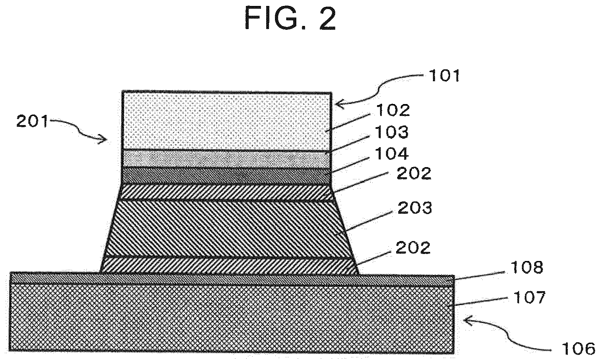

Joint structure 201 manufactured using the solder alloy of the present disclosure is schematically shown in FIG. 2. Joint structure 201 has a structure in which semiconductor element 101 and circuit board 106 are joined via alloy layer 202 and solder joint layer 203.

In order to manufacture joint structure 201, as shown in FIG. 1, solder alloy 105 is placed on plated layer 108 of circuit board 106, and semiconductor element 101 is placed on solder alloy 105 so that solder alloy 105 and metallized layer 104 of semiconductor element 101 come in contact with each other. Subsequently, heating is performed from room temperature to 300°C by increasing the temperature by 10°C per minute, holding the temperature at 300°C for 1 minute, and then cooling is performed from 300°C to room temperature by decreasing the temperature by 10°C per minute so as to form alloy layer 202 between solder alloy 105 and metallized layer 104, and plated layer 108, and therefore joint structure 201 as shown in FIG. 2 can be manufactured.

Alloy layer 202 of joint structure 201 is an intermetallic compound formed in the manufacturing process of the joint structure as described above. In a case where the metallized layer 104 and plated layer 108 are Ni or Cu, alloy layer 202 includes Sn-Ni alloy or Sn-Cu alloy. That is, Sn-Ni alloy or Sn-Cu alloy is included at the interface between metallized layer 104 of semiconductor element 101 and solder joint layer 203 and at the interface between plated layer 108 of the circuit board and solder joint layer 203. Sn-Ni alloy or Sn-Cu alloy is formed in alloy layer 202 between metallized layer 104 and plated layer 108 of the circuit board, and solder joint layer 203 so that metallized layer 104 and plated layer 108 of the circuit board, and solder joint layer 203 are joined to each other by a metal, and therefore favorable joint strength can be obtained. At least one of Te and Au may be contained in the Sn-Ni alloy and the Sn-Cu alloy which may be contained in alloy layer 202. That is, the Sn-Ni alloy or the Sn-Cu alloy included at the interface between metallized layer 104 of semiconductor element 101 and solder joint layer 203 and at the interface between plated layer 108 of the circuit board and solder joint layer 203 may contain at least one of Te and Au. By including at least one of Te and Au in the Sn-Ni alloy and the Sn-Cu alloy, alloy layer 202 becomes a multicomponent alloy, by which the strength of the alloy is improved, and therefore occurrence of cracks in alloy layer 202 can be suppressed even in a case where stress is applied in a heat cycle or the like. Solder joint layer 203 of joint structure 201 contains a metal element such as Sb, Te, and Au contained in solder alloy 105 and has almost the same composition as solder alloy 105 before joining, but in solder joint layer 203, the Sn content decreases by a ratio at which Sn reacted when forming alloy layer 202.

### Examples

### Example 1

As shown in Table 1, a plurality of solder alloys 105 were prepared with changes in Sb content, Te content, and Au content, in which the remainder was Sn, and a tensile test was performed at an ambient temperature of 200°C. For the tensile test, an evaluation sample in which the solder alloy was cast in a dumbbell shape was prepared. As a shape of the evaluation sample, a part to be fixed in the tensile test had a diameter of 6 mm and a length of 20 mm, and a neck part of the dumbbell had a diameter of 3 mm and a length of 20 mm. The tensile test of the evaluation sample was carried out by setting a gap between upper and lower sample-fixing jigs of a tensile testing device to 20 mm so as to fix the evaluation sample, setting the ambient temperature to 200°C, and then pulling the evaluation sample by the tensile testing device such that only the axial force was applied to the evaluation sample.

Elongation (%) of the evaluation sample was defined as a ratio of an increase of the gap between the fixing jigs when the evaluation sample was fractured in the tensile test, with respect to the gap of 20 mm of the fixing jigs before the test. For example, in a case where the gap between the fixing jigs when the evaluation sample was fractured is 40 mm, the elongation is (40 - 20)/20 × 100 = 100 (%).

The measurement results of the elongation (%) in the tensile test are also shown in Table 1.

**Table 1**

| | Sb content (wt%) | Te content (wt%) | Au content (wt%) | Elongation (%) |
|---|---|---|---|---|
| Example 1-1 | 3 | 0.01 | 0.005 | 129 |
| Example 1-2 | 15 | 0.01 | 0.005 | 121 |
| Comparative Example 1-1 | 3 | 0.01 | 0 | 87 |
| Comparative Example 1-2 | 15 | 3 | 0 | 85 |

The result of the tensile test was 129% in Example 1-1 in which the Sb content was 3 wt%, the Te content was 0.01 wt%, and the Au content was 0.005 wt%, and was 121% in Example 1-2 in which the Sb content was 15 wt%, the Te content was 0.01 wt%, and the Au content was 0.005 wt%. These results were favorable results compared to the elongation of 87% in Comparative Example 1-1 not containing Au and the elongation of 85% in Comparative Example 1-2 not containing Au.

Based on the above results, it was revealed that elongation at high temperature was effectively improved by adding Au in addition to Te. By adding both elements of Te and Au, solid solution of Te in the Sn phase and solid solution of Au in the Sn-Te phase generated by the above solid solution are generated, whereby the elongation at higher temperature was considered to be improved compared to Sn-Sb solder to which only Te is added. As a result, it is possible to absorb repetitive stress generated during the heat cycle, and it is possible to realize a high level of reliability of the joint structure.

### Example 2

The joint structure of the present disclosure was prepared as shown in Examples 2-1 to 2-16 (refer to Table 2) below.

### Example 2-1

First, solder alloy 105, semiconductor element 101, and circuit board 106 were prepared. For solder alloy 105, an alloy containing 3 wt% of Sb, 0.01 wt% of Te, and 0.005 wt% of Au, in which the remainder is Sn was prepared. Semiconductor element 101 in which ohmic layer 103 made of Ti was provided on the lower surface of silicon chip 102 having the vertical length of 10 mm, the horizontal length of 10 mm, and the thickness of 0.2 mm, and the metallized layer 104 made of Ni was provided on the lower surface of ohmic layer 103 made of Ti, was prepared. Circuit board 106 has the lead frame made of copper and having the vertical length of 20 mm, the horizontal length of 20 mm, and the thickness of 1 mm, and on the surface of lead frame 107, plated layer 108 made of Ni and having the thickness of 1 µm was provided.

Next, solder alloy 105 having the thickness of 0.1 mm was placed on plated layer 108 made of Ni of the prepared circuit board 106, and furthermore, semiconductor element 101 was placed on solder alloy 105 so that solder alloy 105 comes into contact with metallized layer 104 made of Ni, and was heated from room temperature to 300°C by increasing the temperature by 10°C per minute. After holding the temperature at 300°C for 1 minute, joint structure 201 was manufactured by cooling from 300°C to room temperature by decreasing the temperature by 10°C per minute.

### Example 2-2

Joint structure 201 was produced by setting the Au content of solder alloy 105 at 1 wt% and setting the other conditions to be the same as in Example 2-1.

### Example 2-3

Joint structure 201 was produced by setting the Te content of solder alloy 105 at 1.5 wt% and setting the other conditions to be the same as in Example 2-1.

### Example 2-4

Joint structure 201 was produced by setting the Au content of solder alloy 105 at 1 wt% and setting the other conditions to be the same as in Example 2-3.

### Example 2-5

Joint structure 201 was produced by setting the Sb content of solder alloy 105 at 5 wt% and setting the other conditions to be the same as in Example 2-1.

### Example 2-6

Joint structure 201 was produced by setting the Au content of solder alloy 105 at 1 wt% and setting the other conditions to be the same as in Example 2-5.

### Example 2-7

Joint structure 201 was produced by setting the Te content of solder alloy 105 at 1.5 wt% and setting the other conditions to be the same as in Example 2-5.

### Example 2-8

Joint structure 201 was produced by setting the Au content of solder alloy 105 at 1 wt% and setting the other conditions to be the same as in Example 2-7.

### Example 2-9

Joint structure 201 was produced by setting the Sb content of solder alloy 105 at 10 wt% and setting the other conditions to be the same as in Example 2-1.

### Example 2-10

Joint structure 201 was produced by setting the Au content of solder alloy 105 at 1 wt% and setting the other conditions to be the same as in Example 2-9.

### Example 2-11

Joint structure 201 was produced by setting the Te content of solder alloy 105 at 1.5 wt% and setting the other conditions to be the same as in Example 2-9.

### Example 2-12

Joint structure 201 was produced by setting the Au content of solder alloy 105 at 1 wt% and setting the other conditions to be the same as in Example 2-11.

### Example 2-13

Joint structure 201 was produced by setting the Sb content of solder alloy 105 at 15 wt% and setting the other conditions to be the same as in Example 2-1.

### Example 2-14

Joint structure 201 was produced by setting the Au content of solder alloy 105 at 1 wt% and setting the other conditions to be the same as in Example 2-13.

### Example 2-15

Joint structure 201 was produced by setting the Te content of solder alloy 105 at 1.5 wt% and setting the other conditions to be the same as in Example 2-13.

### Example 2-16

Joint structure 201 was produced by setting the Au content of solder alloy 105 at 1 wt% and setting the other conditions to be the same as in Example 2-15.

### Comparative Example 2

Furthermore, the joint structure was prepared as shown in Comparative Examples 2-1 to 2-15 (refer to Table 2) below.

### Comparative Example 2-1

Joint structure 201 was produced by setting the Sb content of solder alloy 105 at 2 wt% and setting the other conditions to be the same as in Example 2-1.

### Comparative Example 2-2

Joint structure 201 was produced by setting the Te content at 1.5 wt% of solder alloy 105 and the Au content at 1 wt% and setting the other conditions to be the same as in Comparative Example 2-1.

### Comparative Example 2-3

Joint structure 201 was produced by setting the Sb content of solder alloy 105 at 3 wt% and the Te content at 0.005 wt% and setting the other conditions to be the same as in Comparative Example 2-1.

### Comparative Example 2-4

Joint structure 201 was produced by setting the Au content of solder alloy 105 at 1 wt% and setting the other conditions to be the same as in Comparative Example 2-3.

### Comparative Example 2-5

Joint structure 201 was produced by setting the Te content of solder alloy 105 at 0.01 wt% and the Au content at 0 wt% and setting the other conditions to be the same as in Comparative Example 2-3.

### Comparative Example 2-6

Joint structure 201 was produced by setting the Te content of solder alloy 105 at 3 wt% and the Au content at 1.5 wt% and setting the other conditions to be the same as in Comparative Example 2-3.

### Comparative Example 2-7

Joint structure 201 was produced by setting the Sb content of solder alloy 105 at 5 wt% and setting the other conditions to be the same as in Comparative Example 2-3.

### Comparative Example 2-8

Joint structure 201 was produced by setting the Te content of solder alloy 105 at 1.5 wt% and the Au content at 1.5 wt% and setting the other conditions to be the same as in Comparative Example 2-7.

### Comparative Example 2-9

Joint structure 201 was produced by setting the Sb content of solder alloy 105 at 10 wt% and setting the other conditions to be the same as in Comparative Example 2-3.

### Comparative Example 2-10

Joint structure 201 was produced by setting the Te content of solder alloy 105 at 3 wt% and the Au content at 1 wt% and setting the other conditions to be the same as in Comparative Example 2-9.

### Comparative Example 2-11

Joint structure 201 was produced by setting the Sb content of solder alloy 105 at 15 wt% and setting the other conditions to be the same as in Comparative Example 2-3.

### Comparative Example 2-12

Joint structure 201 was produced by setting the Te content of solder alloy 105 at 0.01 wt% and the Au content at 0 wt% and setting the other conditions to be the same as in Comparative Example 2-11.

### Comparative Example 2-13

Joint structure 201 was produced by setting the Te content of solder alloy 105 at 3 wt% and the Au content at 1.5 wt% and setting the other conditions to be the same as in Comparative Example 2-11.

### Comparative Example 2-14

Joint structure 201 was produced by setting the Sb content of solder alloy 105 at 16 wt% and setting the other conditions to be the same as in

### Example 2-1.

### Comparative Example 2-15

Joint structure 201 was produced by setting the Te content of solder alloy 105 at 1.5 wt% and the Au content at 1 wt% and setting the other conditions to be the same as in Comparative Example 2-14.

A heat cycle test was performed on joint structures 201 of Examples 2-1 to 2-16 and Comparative Examples 2-1 to 2-15 so as to evaluate crack resistance. In the heat cycle test, a cycle of -40°C and 150°C for 5 minutes was set as one cycle, and 1000 cycles were performed using a liquid tank test tank. The sample after the test was observed with an ultrasonic microscope and the peeled off area was divided by the joint area to calculate the crack ratio. In a case where the crack ratio was 10% or more, heat generation of the silicon chip cannot be efficiently released to the lead frame, and the result was judged as A for a value less than 10% and as B for a value of 10% or more.

The crack ratio after the heat cycle test and the judgment results are shown in Table 2.

**Table 2**

| | Sb content (wt%) | Te content (wt%) | Au content (wt%) | Crack ratio (%) | Judgment |
|---|---|---|---|---|---|
| Example 2-1 | 3 | 0.01 | 0.005 | 9 | A |
| Example 2-2 | 3 | 0.01 | 1 | 8 | A |
| Example 2-3 | 3 | 1.5 | 0.005 | 7 | A |
| Example 2-4 | 3 | 1.5 | 1 | 9 | A |
| Example 2-5 | 5 | 0.01 | 0.005 | 8 | A |
| Example 2-6 | 5 | 0.01 | 1 | 7 | A |
| Example 2-7 | 5 | 1.5 | 0.005 | 7 | A |
| Example 2-8 | 5 | 1.5 | 1 | 9 | A |
| Example 2-9 | 10 | 0.01 | 0.005 | 5 | A |
| Example 2-10 | 10 | 0.01 | 1 | 6 | A |
| Example 2-11 | 10 | 1.5 | 0.005 | 8 | A |
| Example 2-12 | 10 | 1.5 | 1 | 9 | A |
| Example 2-13 | 15 | 0.01 | 0.005 | 4 | A |
| Example 2-14 | 15 | 0.01 | 1 | 7 | A |
| Example 2-15 | 15 | 1.5 | 0.005 | 9 | A |
| Example 2-16 | 15 | 1.5 | 1 | 7 | A |
| Comparative Example 2-1 | 2 | 0.01 | 0.005 | 31 | B |
| Comparative Example 2-2 | 2 | 1.5 | 1 | 32 | B |
| Comparative Example 2-3 | 3 | 0.005 | 0.005 | 29 | B |
| Comparative Example 2-4 | 3 | 0.005 | 1 | 25 | B |
| Comparative Example 2-5 | 3 | 0.01 | 0 | 29 | B |
| Comparative Example 2-6 | 3 | 3 | 1.5 | 35 | B |
| Comparative Example 2-7 | 5 | 0.005 | 0.005 | 22 | B |
| Comparative Example 2-8 | 5 | 1.5 | 1.5 | 19 | B |
| Comparative Example 2-9 | 10 | 0.005 | 0.005 | 17 | B |
| Comparative Example 2-10 | 10 | 3 | 1 | 31 | B |
| Comparative Example 2-11 | 15 | 0.005 | 0.005 | 19 | B |
| Comparative Example 2-12 | 15 | 0.01 | 0 | 21 | B |
| Comparative Example 2-13 | 15 | 3 | 1.5 | 32 | B |
| Comparative Example 2-14 | 16 | 0.01 | 0.005 | 31 | B |
| Comparative Example 2-15 | 16 | 1.5 | 1 | 33 | B |

The crack ratios were 9% in all Examples 2-1 and 2-4 where the Sb content was 3 wt%, and the judgment was A for each example. On the other hand, the crack ratios were 31% and 32% in Comparative Examples 2-1 and 2-2, respectively, in which the Sb content was 2 wt%, and the judgment was B for each example.

The crack ratios were 4% and 7% in Examples 2-13 and 2-16, respectively, in which the Sb content was 15 wt%, and the judgment was A for each example. On the other hand, the crack ratios were 31% and 33% in Comparative Examples 2-14 and 2-15, respectively, in which the Sb content was 16 wt%, and the judgment was B for each example.

Based on the above results, it was found that crack resistance was improved in a case where Sb was 3 wt% or more and 15 wt% or less. It is considered that this is because in a case where the Sb content is less than 3 wt%, an effect of strengthening dispersion of a Sn-Sb compound cannot be obtained. It is presumed that crack resistance decreases in a case where Sb exceeds 15 wt%, because the strength is improved but the ductility of the solder alloy deteriorates.

In the samples having the composition of Sb content of 3 wt% or more and 15 wt% or less, in a case where the Te content was 0.01 wt% or more and 1.5 wt% or less and the Au content was 0.005 wt% or more and 1 wt% or less in Examples 2-1 to 16, the crack ratio was less than 10%, and a good result that the judgment was A was obtained.

Even in the sample having the composition of the Sb content of 3 wt% or more and 15 wt% or less, in a case where the Au content was 0 wt% as in Comparative Examples 2-5 and 2-12, the crack ratio was 20% or more, and the judgment of B was obtained.

Even in the samples having the Sb content of 3 wt% or more and 15 wt% or less, in a case where the Te content was 0.005 wt% or less as in Comparative Examples 2-3, 2-4, 2-7, 2-9, and 2-11, the crack ratio was 17% or more, and the judgment of B was obtained.

Even in the samples having the composition of the Sb content of 3 wt% or more and 15 wt% or less, in a case where the Te content was 3 wt% or more as in Comparative Examples 2-6, 2-10, and 2-13, the crack ratio was 19% or more, and the judgment of B was obtained.

Even in the samples having the composition of the Sb content of 3 wt% or more and 15 wt% or less, in a case where the Au content was 1.5 wt% or more as in Comparative Examples 2-6, 2-8, and 2-13, the crack ratio was 19% or more, and the judgment of B was obtained.

Based on the above results, it was found that especially excellent crack resistance was realized in the case where the Te content was 0.01 wt% or more and 1.5 wt% or less and the Au content was 0.005 wt% or more and 1 wt% or less. It is considered that this is because in the case where the Te content was 0.005 wt% or less, almost no effect due to the solid solution of Te was obtained. It is presumed that ductility deteriorated and crack resistance deteriorated in the case where the Te content was 3 wt% or more, because Te could not be solutionized and precipitated as a compound.

It is presumed that by adding Au content of at least 0.005 wt%, Au having different ionic radius was complicatedly substituted with Sn in which Te was solutionized, dislocation occurred, whereby elongation at high temperature was improved, and therefore crack resistance was also improved. On the other hand, it is considered that in the case where the Au content exceeded 1 wt%, Au-Sn which is a brittle compound precipitated, and therefore crack resistance was not improved.

### Example 3

The joint structure of the present disclosure was produced as shown in Example 3-1 below.

### Example 3-1

Solder alloy 105, semiconductor element 101, and circuit board 106 were prepared. First, an alloy containing 3 wt% of Sb and 0.01 wt% of Te, in which the remainder was Sn was formed into a plate shape having a thickness of 0.1 mm. Furthermore, Au plating was applied to the upper and lower surfaces of the formed solder alloy by a thickness of 0.19 µm so that a ratio to a weight of the entire alloy plate above became 1 wt%. In this case, the ratio of which Sb was 13 wt%, Te was 0.01 wt%, Au was 1 wt% with respect to the total of the weight of the gold constituting the Au plating and the weight of the formed solder alloy.

Semiconductor element 101 in which ohmic layer 103 made of Ti is provided on the lower surface of silicon chip 102 having the vertical length of 10 mm, the horizontal length of 10 mm, and the thickness of 0.2 mm, and the metallized layer 104 made of Ni was provided on the lower surface of ohmic layer 103 made of Ti, was prepared. For circuit board 106, a board having a vertical length of 20 mm and a horizontal length of 20 mm and having a thickness of 1 mm was prepared. In circuit board 106, the lead frame made of copper was provided, and plated layer 108 made of Ni having a thickness of 1 µm was provided on the surface of lead frame 107.

Next, solder alloy 105 having a thickness of 100.38 µm was placed on plated layer 108 made of Ni of the prepared circuit board 106. Furthermore, semiconductor element 101 was placed on solder alloy 105 so that solder alloy 105 and metallized layer 104 made of Ni come in contact with each other, and heating from room temperature to 300°C was performed by increasing the temperature 10°C per minute. After holding the temperature at 300°C for 1 minute, joint structure 201 was manufactured by cooling from 300°C to room temperature by decreasing the temperature by 10°C per minute. The produced joint structure was subjected to the same heat cycle test as in Example 2, and crack resistance was judged.

The crack ratio after the heat cycle test of Example 3-1 was 8%, and was judged as A. It is considered that this is because in Example 3-1, Au plating was applied to the Sn-Sb-Te solder alloy, and Au diffused into the solder joint layer by heating at the time of joining, and thus the same joint structure as in Example 2-2 was formed. Based on the results of Example 3-1, it became clear that Au may be formed on the surface of the solder alloy if the range is within the composition range of the present disclosure.

According to the solder alloy and the joint structure of the present disclosure, elongation at high temperature was improved and crack resistance of the joint structure was improved, and therefore the solder alloy and the joint structure can be applied to the purpose of joining of semiconductor elements such as power modules.

## Claims

1. A solder alloy comprising:
an Sb content of 3 wt% or more and 15 wt% or less;
a Te content of 0.01 wt% or more and 1.5 wt% or less;
an Au content of 0.005 wt% or more and 1 wt% or less; and
a remainder that is Sn.

2. A joint structure comprising a semiconductor element and a circuit board, wherein the semiconductor element and the circuit board are joined to each other by using the solder alloy of claim 1.

3. The joint structure of claim 2, in which the semiconductor element and the circuit board are joined via a solder joint layer containing Sb, Te, Au, and Sn, the structure comprising:
a Sn-Ni alloy or a Sn-Cu alloy at an interface between a metallized layer of the semiconductor element and the solder joint layer and at an interface between a plated layer of the circuit board and the solder joint layer.

4. The joint structure of Claim 3,
wherein the Sn-Ni alloy or the Sn-Cu alloy contained at the interface between the metallized layer of the semiconductor element and the solder joint layer and at the interface between the plated layer of the circuit board and the solder joint layer contains at least one of Te and Au.

## Patentansprüche

1. Lötlegierung, umfassend:
einen Sb-Gehalt von 3 Gew.-% oder mehr und 15 Gew.-% oder weniger;
einen Te-Gehalt von 0,01 Gew.-% oder mehr und 1,5 Gew.-% oder weniger;
einen Au-Gehalt von 0,005 Gew.-% oder mehr und 1 Gew.-% oder weniger; und
einen Restwert, der Sn ist.

2. Verbindungsstruktur, die ein Halbleiterelement und eine Schaltplatine umfasst, wobei das Halbleiterelement und die Schaltplatine miteinander unter Verwendung der Lötlegierung nach Anspruch 1 verbunden sind.

3. Verbindungstruktur nach Anspruch 2, bei der das Halbleiterelement und die Schaltplatine über eine Lötverbindungsschicht verbunden sind, die Sb, Te, Au und Sn enthält, wobei die Struktur umfasst:
eine Sn-Ni-Legierung oder eine Sn-Cu-Legierung an einer Schnittstelle zwischen einer metallisierten Schicht des Halbleiterelementes und der Lötverbindungschicht und an einer Schnittstelle zwischen einer plattierten Schicht der Schaltplatine und der Lötverbindungschicht.

4. Verbindungstruktur nach Anspruch 3,
wobei die Sn-Ni-Legierung oder die Sn-Cu-Legierung, die an der Schnittstelle zwischen der metallisierten Schicht des Halbleiterelementes und der Lötverbindungschicht und an der Schnittstelle zwischen der plattierten Schicht der Schaltplatine und der Lötverbindungschicht enthalten sind, enthalten mindestens ein Element aus Te und Au.

## Revendications

1. Alliage de brasure comprenant :
une teneur en Sb de 3 % en poids ou plus et de 15 % en poids ou moins ;
une teneur en Te de 0,01 % en poids ou plus et de 1,5 % en poids ou moins ;
une teneur en Au de 0,005 % en poids ou plus et de 1 % en poids ou moins ; et
le reste étant du Sn.

2. Structure de joint comprenant un élément semi-conducteur et une carte de circuit, dans laquelle l'élément semi-conducteur et la carte de circuit sont joints l'un à l'autre par utilisation de l'alliage de brasure de la revendication 1.

3. Structure de joint selon la revendication 2, dans laquelle l'élément semi-conducteur et la carte de circuit sont joints via une couche de joint de brasure contenant Sb, Te, Au et Sn, la structure comprenant :
un alliage Sn-Ni ou un alliage Sn-Cu à une interface entre une couche métallisée de l'élément semi-conducteur et la couche de joint de brasure et à une interface entre une couche plaquée de la carte de circuit et la couche de joint de brasure.

4. Structure de joint selon la revendication 3, dans laquelle l'alliage Sn-Ni ou l'alliage Sn-Cu contenu à l'interface entre la couche métallisée de l'élément semi-conducteur et la couche de joint de brasure et à l'interface entre la couche plaquée de la carte de circuit et la couche de joint de brasure contient au moins l'un parmi Te et Au.
